# EUROPEAN PATENT APPLICATION

(11) **EP 4 325 290 A1**
(43) Date of publication of application: **21.02.2024**
(21) Application number: 22788153.9
(22) Date of filing: 12.04.2022
(51) Int. Cl.: G03F 1/64, G03F 1/66

(54) **PELLICLE FRAME LAMINATE AND METHOD FOR MANUFACTURING PELLICLE USING SAID LAMINATE**

(30) Priority: 13.04.2021 JP 2021067637
(71) Applicant: SHIN-ETSU CHEMICAL CO., LTD., Tokyo 1000005 (JP)
(72) Inventor: YANASE, Yu, Annaka-shi, Gunma 379-0127 (JP); SHIRASAKI, Toru, Annaka-shi, Gunma 379-0127 (JP)
(74) Representative: Meissner Bolte Partnerschaft mbB
(86) International application number: PCT/JP2022/017550
(87) International publication number: WO 2022/220228

(57) **Abstract**

Provided are: a pellicle frame laminate 10 characterized by having a first adhesive layer 11 on an upper end surface 1a of a pellicle frame 1 having the upper end surface and a lower end surface and covering the first adhesive layer with a first protection sheet 21 and by having a second adhesive layer 12 on a lower end surface 1b and covering the second adhesive layer with a second protection sheet 22; and a method for manufacturing a pellicle by removing the first protection sheet 21 of the pellicle frame laminate 10 and providing, to the exposed first adhesive layer 11, a pellicle film which has been prepared separately. According to the present invention, by using a pellicle frame in which the adhesive layers are formed on both the upper end surface and lower end surface of the pellicle frame and both surfaces are protected with the protection sheets, it is possible to assemble a pellicle at a place where an adhesive for the pellicle film cannot be applied.

## Description

### TECHNICAL FIELD

The present invention relates to a pellicle frame laminate attached to a photomask for lithography as a dust guard and a method for manufacturing a pellicle using the same.

### BACKGROUND ART

In recent years, the design rule of LSIs has been oriented to miniaturization to a sub-quarter micron, and accordingly, the wavelength of an exposure light source has been shortened. That is, an exposure light source has shifted from a g-line (436 nm) and an i-line (365 nm) by a mercury lamp to a KrF excimer laser (248 nm), an ArF excimer laser (193 nm), or the like, and EUV exposure using extreme ultra violet (EUV) light having a main wavelength of 13.5 nm has been investigated.

In semiconductor manufacturing such as LSIs and VLSIs or manufacturing of liquid crystal display plates, a pattern is prepared by irradiating a semiconductor wafer or an original plate for liquid crystals with light. However, if dust adheres to a photomask for lithography and a reticle (hereinafter, collectively referred to as "exposure original plate") used in this case, the dust absorbs light or bends light. Therefore, there is such a problem that a transferred pattern is deformed or an edge becomes rough, and in addition, a base becomes black and dirty, so that dimensions, quality, appearance, and the like are impaired.

These operations are typically performed in a clean room, but it is still difficult to keep the exposure original plate clean at all times. Therefore, there is generally adopted a method of attaching a pellicle as a dust guard to the surface of an exposure original plate and then performing exposure. In this case, foreign matters do not directly adhere to the surface of the exposure original plate but adhere to the pellicle, and thus if the focus is set on the pattern of the exposure original plate at the time of lithography, the foreign matters on the pellicle are irrelevant to the transfer.

A basic configuration of the pellicle is such that a pellicle film having high transmittance with respect to light used for exposure is stretched on an upper end face of a pellicle frame made of aluminum, titanium, or the like, and an airtight gasket is formed on a lower end face thereof. An adhesive agent layer formed of a pressure-sensitive adhesive agent is generally used for the airtight gasket, and a protective sheet for protecting the adhesive agent layer is attached thereto. The pellicle film is made of nitrocellulose, cellulose acetate, a fluorine-based polymer, or the like, which well transmits light (g-line (436 nm) and i-line (365 nm) by a mercury lamp, KrF excimer laser (248 nm), ArF excimer laser (193 nm), and the like) used for exposure, and for EUV exposure, an ultrathin silicon film or a carbon film has been investigated as a pellicle film.

Unlike the conventional transmissive exposure original plate, the EUV exposure original plate is a reflective type. Therefore, the EUV light passes through the pellicle film twice. When the EUV light transmittance of the pellicle film is 80%, the final transmittance after the EUV light passes through the pellicle film twice is 64%. To improve the final transmittance, it is necessary to extremely increase the EUV light transmittance of the pellicle film. To obtain extremely high transmittance, it is necessary to reduce the film thickness of the pellicle film. As a result, the pellicle film is significantly easily cracked.

When a pellicle including a pellicle film that is easily cracked as described above is manufactured by a pellicle manufacturer and shipped to a user, there is such a problem that a pellicle film (thin film) is frequently broken due to vibration or atmospheric pressure fluctuation during transportation. To eliminate the breakage of the thin film during transportation, it is considered to prepare a pellicle film at a place adjacent to a photomask manufacturing plant of a user, attach the pellicle film to a pellicle frame, and complete the pellicle. That is, preparing the pellicle film at a place where the pellicle is finally used can eliminate the need for long-distance transportation, and thus can eliminate the risk of breakage during transportation. A pellicle frame to be combined with a pellicle film may be manufactured by a pellicle manufacturer as in conventional cases and shipped to a pellicle assembly plant adjacent to a photomask manufacturing plant. In a pellicle assembly plant, it has been investigated to assemble a pellicle by applying a solution-like adhesive agent to the upper end face of a pellicle frame, and then combining a thin film made of polysilicon to solidify the adhesive agent. However, the photomask manufacturing plant is typically located at one corner of a wafer process plant, and use of an organic material is limited, and therefore it is difficult to apply an adhesive agent.

Patent Document 1 proposes a pellicle using a silicone-based pressure-sensitive adhesive agent as an adhesive agent for adhering a pellicle film made of a fluororesin to the upper end face of a pellicle frame. In this technique, the pellicle film is attached to the pellicle frame in a series of flows, and thus it is necessary to ship the pellicle with the pellicle film, arising a risk of breakage of the pellicle film.

In addition, as a related technique, Patent Document 2 describes manufacturing of a pellicle including attaching a predetermined adhesive sheet to a pellicle film and bonding a resultant to a pellicle frame.

### PRIOR ART DOCUMENTS

### PATENT DOCUMENTS

Patent Document 1: JP-A 2001-249441
Patent Document 2: WO 2016/175019

### SUMMARY OF INVENTION

### TECHNICAL PROBLEM

The present invention has been made in view of the above circumstances, and an object thereof is to provide a pellicle frame laminate capable of smoothly manufacturing a pellicle by attaching a pellicle frame to a pellicle film even at a place where application of an adhesive agent for a pellicle film is impossible, and a method for manufacturing a pellicle using the pellicle frame laminate.

### SOLUTION TO PROBLEM

To achieve the above object, the present invention provides a pellicle frame laminate including a first adhesive agent layer on an upper end face of a pellicle frame having the upper end face and a lower end face, the first adhesive agent layer being covered with a first protective sheet, and a second adhesive agent layer on the lower end face, the second adhesive agent layer being covered with a second protective sheet.

That is, the present invention provides a pellicle frame laminate in which adhesive agent layers are formed on both the upper end face and the lower end face of the pellicle frame and both faces are protected by protective sheets. Using the pellicle frame laminate with a double-sided adhesive agent, in a pellicle manufacturing plant, a pellicle can be completed by peeling a protective cover on the upper end face of the pellicle frame to expose the adhesive agent layer and bringing a pellicle film into contact therewith. Therefore, it is possible to omit conventionally problematic application of an adhesive agent for a pellicle film in a pellicle manufacturing plant.

The present invention provides a pellicle frame laminate and a method for manufacturing a pellicle described below.
1. A pellicle frame laminate comprising: a first adhesive agent layer on an upper end face of a pellicle frame having the upper end face and a lower end face, the first adhesive agent layer being covered with a first protective sheet; and a second adhesive agent layer on the lower end face, the second adhesive agent layer being covered with a second protective sheet.
2. The pellicle frame laminate of 1, wherein the adhesive agent layer is formed of a pressure-sensitive adhesive agent.
3. The pellicle frame laminate of 1 or 2, wherein a shape or a color of the first protective sheet is different from a shape or a color of the second protective sheet.
4. The pellicle frame laminate of any one of 1 to 3, wherein the first protective sheet or the second protective sheet has a frame shape conforming to a shape of the pellicle frame.
5. The pellicle frame laminate of any one of 1 to 4, wherein the first protective sheet or the second protective sheet has a tab.
6. The pellicle frame laminate of 5, wherein the first protective sheet or the second protective sheet has a frame shape conforming to a shape of the pellicle frame, and the tab protrudes from an outer edge portion of the pellicle frame.
7. The pellicle frame laminate of 5 or 6, wherein the tab is provided at a corner portion of the first protective sheet or the second protective sheet.
8. The pellicle frame laminate of any one of 5 to 7, wherein each of the first protective sheet and the second protective sheet has a tab, and the tabs are disposed so as to have a region in which the tab of the first protective sheet and the tab of the second protective sheet do not overlap each other when the pellicle frame is observed from a direction perpendicular to a plane including the upper end face.
9. The pellicle frame laminate of any one of 5 to 7, wherein each of the first protective sheet and the second protective sheet has a tab, the pellicle frame, the first protective sheet, and the second protective sheet have a quadrangular frame shape, and when the pellicle frame is observed from a direction perpendicular to a plane including the upper end face, a side of the quadrangle on which the tab of the first protective sheet is disposed and a side of the quadrangle on which the tab of the second protective sheet is disposed are different sides.
10. The pellicle frame laminate of 9, wherein the side of the quadrangle on which the tab of the first protective sheet is disposed and the side of the quadrangle on which the tab of the second protective sheet is disposed are sides adjacent to each other.
11. The pellicle frame laminate of 9, wherein the side of the quadrangle on which the tab of the first protective sheet is disposed and the side of the quadrangle on which the tab of the second protective sheet is disposed are sides facing each other.
12. The pellicle frame laminate of any one of 5 to 11, wherein each of the first protective sheet and the second protective sheet has a tab, and a length of the tab of the first protective sheet is different from a length of the tab of the second protective sheet.
13. The pellicle frame laminate of any one of 4 to 12, wherein an outer diameter (a tab if any excluded) of the first protective sheet or an outer diameter of the second protective sheet has a region of ± 10% of an outer diameter of the pellicle frame.
14. The pellicle frame laminate of any one of 4 to 13, wherein an inner diameter (a tab if any excluded) of the first protective sheet or an inner diameter of the second protective sheet has a region of ± 10% of an inner diameter of the pellicle frame.
15. The pellicle frame laminate of any one of 4 to 14, wherein the first protective sheet or the second protective sheet has a region having a width wider than a width of the pellicle frame.
16. The pellicle frame laminate of any one of 4 to 15, wherein among the first protective sheet and the second protective sheet, one protective sheet has a region having an inner diameter smaller than 90% of an inner diameter of the pellicle frame and having a width wider than a width of the pellicle frame, and the other protective sheet has a region having an inner diameter being ± 10% of an inner diameter of the pellicle frame.
17. The pellicle frame laminate of any one of 1 to 16, which is used as a pellicle frame of a pellicle for EUV exposure.
18. A packaged product obtained by packaging the pellicle frame laminate of any one of 1 to 17 with a housing container having a tray on which the pellicle frame laminate is placed and a lid.
19. A method for manufacturing a pellicle, the method comprising peeling off the first protective sheet of the pellicle frame laminate of any one of 1 to 17, attaching a pellicle film separately prepared to the exposed first adhesive agent layer, and assembling the pellicle film to the pellicle frame.
20. The method for manufacturing a pellicle of 19, wherein the pellicle frame laminate is a pellicle frame laminate after being transported.
21. The method for manufacturing a pellicle of 20, wherein the transportation includes transportation under an environment having a change in atmospheric pressure.
22. The method for manufacturing a pellicle of any one of 19 to 21, wherein the pellicle film is formed on a frame-like support frame, and the pellicle film is assembled to the pellicle frame by attaching the support frame to a first adhesive agent layer.
23. The method for manufacturing a pellicle of any one of 19 to 22, wherein the pellicle to be assembled is a pellicle for EUV exposure.
24. A transportation method for transporting the pellicle frame laminate of any one of 1 to 17 or the packaged product of 18 under an environment accompanied by a change in atmospheric pressure.

### ADVANTAGEOUS EFFECTS OF INVENTION

The present invention can assemble a pellicle even in a place where application of an adhesive agent for a pellicle film is impossible by forming an adhesive agent layer on both an upper end face and a lower end face of a pellicle frame and using a pellicle frame protected by a protective sheet on both faces. In addition, the thin film can be fixed only by peeling off the protective sheet of the adhesive agent layer and bringing the pellicle film into contact in manufacturing the pellicle, and thus the assembly process can be simplified.

### BRIEF DESCRIPTION OF DRAWINGS

[FIG. 1] FIG. 1 is a schematic cross-sectional view illustrating an example of a pellicle frame laminate of the present invention.
[FIG. 2] FIG. 2 illustrates an example of a pellicle frame, in which FIG. 2(A) is a plan view as viewed from an upper end face side, and FIG. 2(B) is a front view as viewed from a short side outer face side.
[FIG. 3] FIG. 3 illustrates an example of a protective sheet used in the present invention, in which FIG. 3(A) is a plan view of a first protective sheet, and FIG. 3(B) is a plan view of a second protective sheet.
[FIG. 4] FIG. 4 is a schematic view for explaining variations of disposition of tabs of a protective sheet, in which FIG. 4(A) is a schematic view of a first protective sheet, and FIG. 4(B) is a schematic view of a second protective sheet.

### DESCRIPTION OF EMBODIMENTS

Hereinafter, the present invention is described in more detail.

The present invention is a pellicle frame laminate in which an adhesive agent layer is formed on both an upper end face and a lower end face of a pellicle frame and both are protected by a protective sheet.

If the pellicle frame used in the present invention has a frame shape, the shape thereof corresponds to the shape of a photomask to which a pellicle is attached. In general, it has a quadrangular (rectangular or square) frame shape.

In addition, the pellicle frame includes a face for providing a pellicle film (herein, an upper end face) and a face facing a photomask when the photomask is attached (herein, a lower end face).

The material of the pellicle frame is not limited, and a known material can be used. Examples thereof include Si, SiO₂, SiN, quartz, invar, titanium, a titanium alloy, an aluminum alloy, and the like, and among them, metal is preferable from the viewpoint of ease of processing and lightweight.

The size of the pellicle frame is not particularly limited, but the height of the pellicle for EUV is limited to 2.5 mm or less, and thus the thickness of the pellicle frame for EUV is smaller than that of the pellicle and is less than 2.5 mm.

In addition, the thickness of the pellicle frame for EUV is preferably 1.5 mm or less in consideration of the thickness of a pellicle film, a mask adhesive agent, or the like.

In addition, jig holes for a handling jig or used for peeling the pellicle from the photomask are typically provided on the outer side face of the pellicle frame. The size of the jig hole is such that the length in the thickness direction of the pellicle frame (diameter in the case of a circle) is from 0.5 to 1.0 mm. The shape of the jig hole is not particularly limited, and may be circular or rectangular.

In addition, the pellicle frame is provided with a ventilation part for alleviating a change in pressure inside and outside the pellicle. The shape and the number of the ventilation part are not particularly limited. A recessed portion may be provided in an upper end face or a lower end face of the pellicle frame to form the ventilation part. The ventilation part can be provided with a filter to prevent foreign matters from entering the pellicle. The place where the filter is provided is not particularly limited, and examples thereof include the inner side face of the pellicle frame, the inside of the ventilation part, and the outer side face of the pellicle frame.

An adhesive agent for a pellicle film is provided on the upper end face of the pellicle frame. The term "adhesive agent" as used herein includes not only an ordinary adhesive agent but also a pressure-sensitive adhesive agent. The material of the adhesive agent is not limited, and there can be used a known resin material such as a silicone-based pressure-sensitive adhesive agent or an acrylic-based pressure-sensitive adhesive agent. To strongly hold the pellicle film, it is preferable to employ a pressure-sensitive adhesive agent having strong adhesive force. The shape of the adhesive agent is not particularly limited, but it is preferable to flatten the adhesive agent so that the pellicle film and the pellicle frame can be bonded to each other with a weak force when assembling the pellicle film. The thickness of the adhesive agent layer is not particularly limited, but the height of the pellicle is limited to 2.5 mm, and thus it is preferably 0.5 mm or less.

Further, an adhesive agent for a photomask to be attached to the photomask is formed on the lower end face of the pellicle frame. The term "adhesive agent" as used herein includes not only an ordinary adhesive agent but also a pressure-sensitive adhesive agent. In general, the adhesive agent for a photomask is preferably provided over the entire circumference of the pellicle frame. The material of the adhesive agent is not particularly limited, and there can be used a known resin material such as a silicone-based pressure-sensitive adhesive agent or an acrylic-based pressure-sensitive adhesive agent. The shape of the adhesive agent for a photomask is not particularly limited, and flattening may be performed. The thickness of the adhesive agent layer is not particularly limited, but the height of the pellicle is limited to 2.5 mm, and thus it is preferably 0.5 mm or less.

In the pellicle frame laminate of the present invention, a first adhesive agent layer is provided on an upper end face of the pellicle frame, the first adhesive agent layer is covered with a first protective sheet, a second adhesive agent layer is provided on the lower end face, and the second adhesive agent layer is covered with a second protective sheet. That is, in the present invention, in such a manner of covering the adhesive agent for a pellicle film and the adhesive agent for a photomask described above, protective sheets for protecting these adhesive agents are provided on the respective adhesive agents. In the following description, the first protective sheet and the second protective sheet may be simply referred to as "protective sheet".

The material of the protective sheet is not particularly limited, and for example, there can be used polyethylene terephthalate (PET), polytetrafluoroethylene (PTFE), tetrafluoroethylene-perfluoroalkyl vinyl ether copolymer (PFA), polyethylene (PE), polycarbonate (PC), polyvinyl chloride (PVC), and polypropylene (PP). If necessary, a release agent such as a silicone-based release agent or a fluorine-based release agent may be applied to the surface of the protective sheet. Applying the release agent makes it easier to peel off the protective sheet from the adhesive agent layer.

The shape of the protective sheet is not particularly limited as long as it has a size capable of completely covering the adhesive agent. The protective sheet desirably has a frame shape conforming to the shape of the pellicle frame. Compared to the case except for the frame shape (for example, the form of a sheet over the entire face), the frame shape is better for handleability, easier for cleaning, and thus economic and resource-friendly. In addition, the shape of the protective sheet may be different between the side of the adhesive agent for a pellicle film and the side of the adhesive agent for a photomask.

If the protective sheet has a frame shape, it is desirable that the outer diameter of the protective sheet has a region of ± 10% of the outer diameter of the pellicle frame in consideration of handleability when a jig pin is inserted into a jig hole provided in the outer side face of the pellicle frame. The outer diameter of the protective sheet means the size from the center to the outer peripheral edge of the protective sheet, and when there is a tab, the outer diameter is the size to the outer peripheral edge excluding the tab.

In addition, it is desirable that the inner diameter of the protective sheet has a region of ± 10% of the inner diameter of the pellicle frame in order to easily inspect the inner side face of the pellicle frame after the protective sheet is attached. The inner diameter of the protective sheet means the size from the center to the inner peripheral edge of the protective sheet, and when there is a tab, the inner diameter is the size to the inner peripheral edge excluding the tab.

The protective sheet can also have a region having a width wider than the width of the pellicle frame. The protective sheet can be easily handled using a suction pad such as a vacuum pad.

There is a region in which among the first protective sheet and the second protective sheet, one protective sheet has an inner diameter smaller than 90% of an inner diameter of a pellicle frame, and has a region having a width wider than a width of the pellicle frame, and a region in which the other protective sheet has an inner diameter being ± 10% of an inner diameter of the pellicle frame. This is because using such a protective sheet allows easy inspection of the inner side face of the pellicle frame in a state of a pellicle frame laminate in which the adhesive agent layer is covered with the protective sheet.

The thickness of the protective sheet is not particularly limited, but is preferably from 0.05 to 0.5 mm. If the thickness of the protective sheet is more than 0.5 mm, pliability (flexibility) of the protective sheet is lost, and deformation of the adhesive agent layer may occur. In addition, if the thickness of the protective sheet is less than 0.05 mm, the protective sheet becomes too soft, and the handling property is poor.

The shape or color of the first protective sheet is desirably different from the shape or color of the second protective sheet. The protective sheets have different shapes or colors each other, thereby allowing easy determination of the upper and lower positions of the pellicle frame and improvement in the assembly workability of the pellicle.

When the protective sheet is peeled off, a tab may be provided on a part of the protective cover so that the protective sheet can be easily gripped. The tab may be disposed in a mode of protruding from the outer edge portion of the pellicle frame or at a corner portion of the protective sheet. Providing this tab allows easy peeling off the protective sheet. In addition, the number of tabs provided on the protective sheet may be one or more.

Regarding the disposition of the tabs, it is desirable to dispose the tabs so as to have a region in which the tab of the first protective sheet and the tab of the second protective sheet do not overlap each other when the pellicle frame is observed from a direction perpendicular to the plane including the upper end face from the viewpoint of easily peeling off each protective sheets and further improving the work efficiency.

In addition, in a case where the pellicle frame, the first protective sheet, and the second protective sheet have a quadrangular frame shape, when the pellicle frame is observed from a direction perpendicular to a plane including the upper end face, a side of the quadrangle on which the tab of the first protective sheet is disposed and a side of the quadrangle on which the tab of the second protective sheet is disposed are preferably different sides. Specific examples of the mode include a mode in which the side of the quadrangle on which the tab of the first protective sheet is disposed and the side of the quadrangle on which the tab of the second protective sheet is disposed are adjacent sides, and a mode in which the side of the quadrangle on which the tab of the first protective sheet is disposed and the side of the quadrangle on which the tab of the second protective sheet is disposed are opposite sides.

The length of the tab of the first protective sheet is different from the length of the tab of the second protective sheet, and thus the handleability of the protective sheet can be improved.

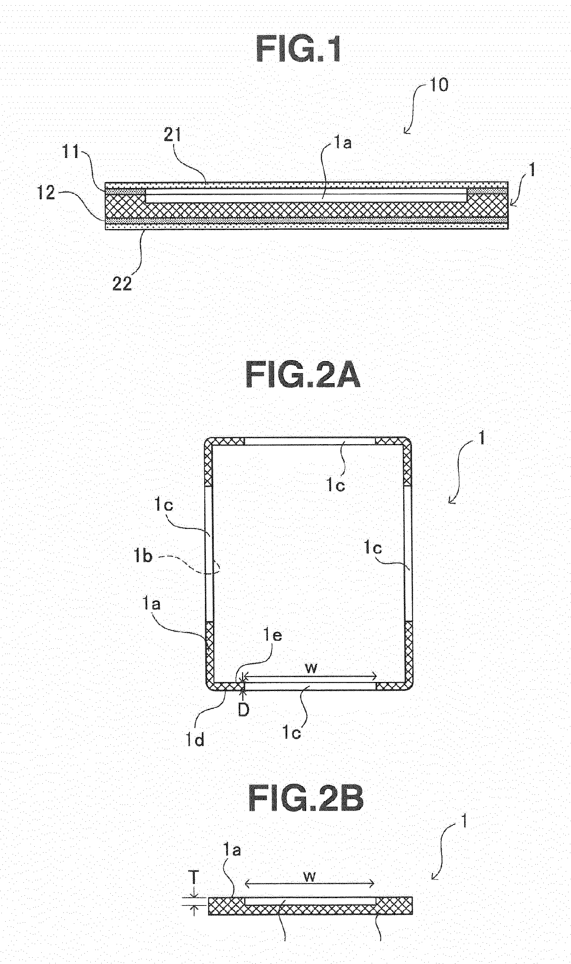

FIG. 1 is a schematic cross-sectional view illustrating an example of a pellicle frame laminate, and this pellicle frame laminate 10 is a laminate in which a first adhesive agent layer 11 is provided on an upper end face 1a of a pellicle frame 1 having the upper end face 1a and a lower end face 1b, the first adhesive agent layer is covered with a first protective sheet 21, a second adhesive agent layer 12 is provided on the lower end face 1b, and the second adhesive agent layer is covered with a second protective sheet 22.

FIG. 2(A) is a plan view of the pellicle frame 1 as viewed from a side of the upper end face, and FIG. 2(B) is a front view as viewed from an outer face side of a short side. In each drawing, reference numeral 1a denotes an upper end face of a pellicle frame, and reference numeral 1b denotes a lower end face of the pellicle frame. In the upper end face of the pellicle frame 1 of FIG. 1, each of recessed portions 1c and 1c are provided in the upper end face on the short side, and each of recessed portions 1c and 1c are provided in the upper end face on the long side, so that a total of four recessed portions are provided. The recessed portions are each formed to communicate from an outer side face 1d to an inner side face 1e.

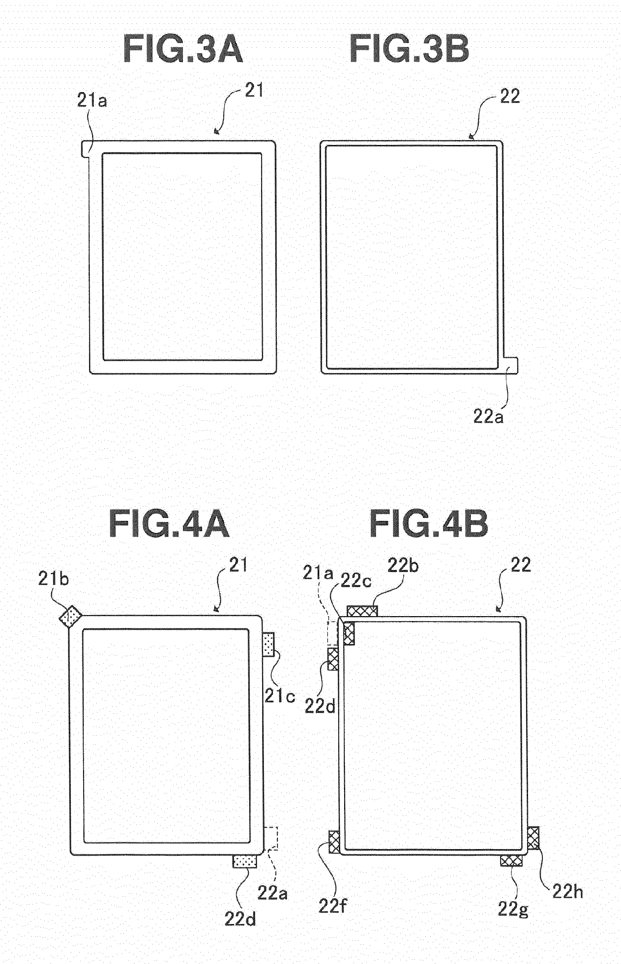

FIG. 3(A) is a plan view of the first protective sheet 21, and FIG. 3(B) is a plan view of the second protective sheet 22. In FIG. 3(A), the first protective sheet has a wide frame shape, and a substantially quadrangular tab 21a protrudes from the outer edge portion of the pellicle frame in the vicinity of one end portion (corner portion) on the long side of the protective sheet. In contrast, as illustrated in FIG. 3(B), the second protective sheet 22 has a frame shape narrower than the first protective sheet, and a substantially quadrangular tab 22a protrudes from the outer edge portion of the pellicle frame in the vicinity of one end portion (corner portion) on the long side of the protective sheet. However, when the pellicle frame is observed from the direction perpendicular to the plane including the upper end face, a long side of the quadrangle on which the tab of the first protective sheet is disposed and a long side of the quadrangle on which the tab of the second protective sheet is disposed do not overlap each other, and are opposite to each other.

FIG. 4 illustrates variations of the disposition of tabs of the protective sheet illustrated in FIG. 3. In addition to the tabs illustrated in FIG. 3, various tab disposition modes are exemplified. FIG. 4(A) illustrates variations (21b to 21d) of the tab provided on the first protective sheet, and exemplifies the tab 21b provided at one area (corner) of the four corners of the first protective sheet 21, the tab 21c provided in the middle of a long side, and the tab 21d provided in the vicinity of a corner on a short side. As illustrated in FIG. 4(A), each of the tabs (21b to 21d) is disposed so as not to overlap the tab 22a of the second protective sheet located below the pellicle frame when viewed from the top.

In contrast, FIG. 4(B) illustrates variations (22b to 22h) of the tab provided on the second protective sheet, and examples thereof include the tab 22b provided in the vicinity of a corner portion on a short side of the second protective sheet 22, the tab 22c provided inside the protective sheet 22, and the tabs 22d, 22f, and 22h provided in the middle of a long side or in the vicinity of a corner portion. As illustrated in FIG. 4(B), each tab (22b to 22h) is disposed so as not to overlap the tab 21a of the first protective sheet located above the pellicle frame when viewed from the top.

Although the shape of the tab is a square or rectangular quadrangle as illustrated in the drawing, various shapes such as a shape having a curved portion such as an arc in a part thereof can be adopted.

### [Method of transport to pellicle assembly plant]

Hereinafter, a method for transporting the pellicle frame laminate to a pellicle assembly plant is described, but it is merely an example, and the interpretation of the present invention is not limited.

The pellicle frame laminate is housed in a dedicated container, and a pellicle is assembled and transported to a plant. The shape of the dedicated housing container is not particularly limited, but a housing container having a structure including a lid portion and a tray portion is preferable from the viewpoint of ease of cleaning of the housing container. The material of the housing container is not particularly limited, and resin such as polycarbonate or metal such as aluminum can be used. After the pellicle frame laminate is housed in the housing container, four corners of the housing container are fastened with clips. The material of the clips is not limited. The clip-attached housing container is placed in a clean bag, and the bag is closed with a tape. This can be packed in a cardboard box together with a cushioning material and transported to the pellicle assembly plant.

The pellicle frame laminate is not attached with a pellicle film, and thus there is no problem of breakage of a pellicle film even if the pellicle frame laminate is transported to a pellicle assembly plant under an environment having a change in atmospheric pressure. The transportation method involves various environments such as the sky on an airplane, and vacuuming a packaged product or a laminate placed in a bag.

### [Method for producing pellicle in pellicle assembly plant]

A method for producing a pellicle in a pellicle assembly plant includes: a step of taking out a pellicle frame laminate from a housing container; a step of peeling off a first protective sheet existing on an upper end face side of a pellicle frame; and a step of pressure-bonding a pellicle film to an exposed first adhesive agent layer.

The method for taking out the pellicle frame from the housing container is not particularly limited, and examples thereof include a method of inserting a jig into a jig hole of the pellicle frame after lifting the protective sheet, and lifting the pellicle frame, and a method of attaching a suction pad to a first protective sheet existing on the upper end face side of the pellicle frame and lifting through suction.

The method for peeling off the protective sheet on the upper end face of the pellicle frame is not particularly limited, and for example, the protective sheet may be peeled off manually or automatically.

The method for pressure-bonding the pellicle film to the exposed first adhesive agent layer is not particularly limited. The first adhesive agent layer is made of an adhesive agent, and thus it is possible to fix the pellicle film by placing the pellicle film on the adhesive agent, without strongly pressing the pellicle film simply. After preparing the pellicle film that is larger than the pellicle frame to assemble the pellicle frame, an extra pellicle film may be cut, or a pellicle film cut previously to the size of the pellicle frame may be bonded to the pellicle frame. The latter method is preferably employed because the possibility of foreign matter adhesion is reduced.

The pellicle film is not limited to a thin film, and a pellicle film including a support frame that supports the pellicle film may also be adopted. For example, as described in Patent Document 2 described above, there can also be employed a method of forming a pellicle film on a silicon wafer and removing the silicon wafer by back etching only at a portion used as the pellicle film to prepare the pellicle film. In this case, the pellicle film is obtained in a state of being supported by the silicon frame. In the method for manufacturing a pellicle of the present invention, bonding the silicon frame to an adhesive agent for a pellicle film allows easy assembly of a pellicle film to a pellicle frame to manufacture the pellicle while suppressing damage to the pellicle film when the pellicle film is bonded to the pellicle frame.

As described above, adopting the pellicle frame laminate of the present invention and the method for manufacturing a pellicle using the same (method for assembling a pellicle) eliminates necessity of transporting a pellicle film for a long time and allows great reduction in the risk of breakage of the pellicle film.

### EXAMPLES

Hereinafter, embodiments are described, but the present invention can implement many modes and should not be construed as being limited to the contents described in the embodiments. In addition, the numerical values described in the Examples are merely Examples, and the interpretation of the present invention is not limited.

An example of the pellicle frame is illustrated in FIG. 2(A) (outer dimensions: 150 mm × 118 mm × 1.5 mm, frame width: 4.0 mm). In addition, although it is not specifically illustrated, on the outer side face of the long side of the pellicle frame, jig holes having a diameter of 1 mm × a depth of 1.2 mm are provided at two positions 52 mm away from the center of the side in the corner direction. In addition, as illustrated in FIG. 2(B), on the upper end face at the center of each side of the pellicle frame, a notched part having a width (W) of 90 mm × a height (T) of 0.1 mm × a depth (D) of 4 mm is provided. This notched part is formed from the outer side face to the inner side face.

On the upper end face of the pellicle frame excluding the notched part of the frame, a pressure-sensitive adhesive agent for a pellicle film is provided with a thickness of 0.1 mm. The surface of the adhesive agent layer is flattened. In contrast, on the lower end face of the pellicle frame, a pressure-sensitive adhesive agent for a photomask is provided with a thickness of 0.1 mm over the entire circumference. The surface of the adhesive agent layer is flattened.

The adhesive agent for a pellicle film and the adhesive agent for a photomask are provided with a protective sheet (outer dimensions: 151 mm × 117 mm, width 6 mm, thickness 0.13 mm) for protecting the pressure-sensitive adhesive agent during transportation. In this protective sheet, a tab is disposed in the vicinity of the corner portion on the long side so as to protrude from the outer edge portion of the pellicle frame, and is illustrated in FIGS. 3(A) and 3(B) described above.

When a pellicle frame including a pellicle frame, a pressure-sensitive adhesive agent, and protective sheets is viewed from the side, a schematic view of such a laminate is illustrated in FIG. 1.

### REFERENCE SIGNS LIST

- 10: pellicle frame laminate
- 1: pellicle frame
- 1a: upper end face of pellicle frame
- 1b: lower end face of pellicle frame
- 1c: notched part
- 1d: outer side face of pellicle frame
- 1e: inner side face of pellicle frame
- 11: first adhesive agent layer (for pellicle film)
- 12: second adhesive agent layer (for photomask)
- 21: first protective sheet
- 22: second protective sheet
- 21a: tab (first protective sheet)
- 22a: tab (second protective sheet)

## Claims

1. A pellicle frame laminate comprising:
a first adhesive agent layer on an upper end face of a pellicle frame having the upper end face and a lower end face, the first adhesive agent layer being covered with a first protective sheet; and
a second adhesive agent layer on the lower end face, the second adhesive agent layer being covered with a second protective sheet.

2. The pellicle frame laminate of claim 1, wherein the adhesive agent layer is formed of a pressure-sensitive adhesive agent.

3. The pellicle frame laminate of claim 1 or 2, wherein a shape or a color of the first protective sheet is different from a shape or a color of the second protective sheet.

4. The pellicle frame laminate of claim 1 or 2, wherein the first protective sheet or the second protective sheet has a frame shape conforming to a shape of the pellicle frame.

5. The pellicle frame laminate of claim 1 or 2, wherein the first protective sheet or the second protective sheet has a tab.

6. The pellicle frame laminate of claim 5, wherein the first protective sheet or the second protective sheet has a frame shape conforming to a shape of the pellicle frame, and the tab protrudes from an outer edge portion of the pellicle frame.

7. The pellicle frame laminate of claim 5, wherein the tab is provided at a corner portion of the first protective sheet or the second protective sheet.

8. The pellicle frame laminate of claim 5, wherein each of the first protective sheet and the second protective sheet has a tab, and the tabs are disposed so as to have a region in which the tab of the first protective sheet and the tab of the second protective sheet do not overlap each other when the pellicle frame is observed from a direction perpendicular to a plane including the upper end face.

9. The pellicle frame laminate of claim 5, wherein each of the first protective sheet and the second protective sheet has a tab, the pellicle frame, the first protective sheet, and the second protective sheet have a quadrangular frame shape, and when the pellicle frame is observed from a direction perpendicular to a plane including the upper end face, a side of the quadrangle on which the tab of the first protective sheet is disposed and a side of the quadrangle on which the tab of the second protective sheet is disposed are different sides.

10. The pellicle frame laminate of claim 9, wherein the side of the quadrangle on which the tab of the first protective sheet is disposed and the side of the quadrangle on which the tab of the second protective sheet is disposed are sides adjacent to each other.

11. The pellicle frame laminate of claim 9, wherein the side of the quadrangle on which the tab of the first protective sheet is disposed and the side of the quadrangle on which the tab of the second protective sheet is disposed are sides facing each other.

12. The pellicle frame laminate of claim 5, wherein each of the first protective sheet and the second protective sheet has a tab, and a length of the tab of the first protective sheet is different from a length of the tab of the second protective sheet.

13. The pellicle frame laminate of claim 4, wherein an outer diameter (a tab if any excluded) of the first protective sheet or an outer diameter of the second protective sheet has a region of ± 10% of an outer diameter of the pellicle frame.

14. The pellicle frame laminate of claim 4, wherein an inner diameter (a tab if any excluded) of the first protective sheet or an inner diameter of the second protective sheet has a region of ± 10% of an inner diameter of the pellicle frame.

15. The pellicle frame laminate of claim 4, wherein the first protective sheet or the second protective sheet has a region having a width wider than a width of the pellicle frame.

16. The pellicle frame laminate of claim 4, wherein among the first protective sheet and the second protective sheet, one protective sheet has a region having an inner diameter smaller than 90% of an inner diameter of the pellicle frame and having a width wider than a width of the pellicle frame, and the other protective sheet has a region having an inner diameter being ± 10% of an inner diameter of the pellicle frame.

17. The pellicle frame laminate of claim 1 or 2, which is used as a pellicle frame of a pellicle for EUV exposure.

18. A packaged product obtained by packaging the pellicle frame laminate of claim 1 or 2 with a housing container having a tray on which the pellicle frame laminate is placed and a lid.

19. A method for manufacturing a pellicle, the method comprising peeling off the first protective sheet of the pellicle frame laminate of claim 1 or 2, attaching a pellicle film separately prepared to the exposed first adhesive agent layer, and assembling the pellicle film to the pellicle frame.

20. The method for manufacturing a pellicle of claim 19, wherein the pellicle frame laminate is a pellicle frame laminate after being transported.

21. The method for manufacturing a pellicle of claim 20, wherein the transportation includes transportation under an environment having a change in atmospheric pressure.

22. The method for manufacturing a pellicle of claim 19, wherein the pellicle film is formed on a frame-like support frame, and the pellicle film is assembled to the pellicle frame by attaching the support frame to a first adhesive agent layer.

23. The method for manufacturing a pellicle of claim 19, wherein the pellicle to be assembled is a pellicle for EUV exposure.

24. A transportation method for transporting the pellicle frame laminate of claim 1 under an environment accompanied by a change in atmospheric pressure.

25. A transportation method for transporting the packaged product of claim 18 under an environment accompanied by a change in atmospheric pressure.
